# EUROPEAN PATENT SPECIFICATION

(11) **EP 3 263 327 B1**
(45) Date of publication and mention of the grant of the patent: **06.11.2024**
(21) Application number: 16755325.4
(22) Date of filing: 18.02.2016
(51) Int. Cl.: B32B 9/00, H01B 5/14, C23C 14/00, H01L 31/18, C08J 7/04

(54) **LIGHT-TRANSMITTING FILM**
LICHTDURCHLÄSSIGE FOLIE
FILM DE TRANSMISSION DE LUMIÈRE

(30) Priority: 24.02.2015 JP 2015034052; 10.02.2016 JP 2016023802
(43) Date of publication of application: 03.01.2018
(73) Proprietor: Nitto Denko Corporation, Ibaraki-shi, Osaka 567-8680 (JP)
(72) Inventor: FUJINO, Nozomi, Ibaraki-shi Osaka 567-8680 (JP); NASHIKI, Tomotake, Ibaraki-shi Osaka 567-8680 (JP)
(74) Representative: Grünecker Patent- und Rechtsanwälte PartG mbB
(86) International application number: PCT/JP2016/054678
(87) International publication number: WO 2016/136578

(56) References cited:
- JP-A- 2001 047 549
- JP-A- 2002 157 929
- JP-A- 2002 279 835
- JP-A- 2013 001 009
- JP-A- 2014 069 572
- JP-A- H1 170 610

## Description

### TECHNICAL FIELD

The present invention relates to a light transmitting film. In particular, the present invention relates to a light transmitting film suitably used for optical use.

### BACKGROUND ART

Conventionally, it has been known that a light transmitting film such as a transparent conductive film including a transparent conductive layer is used for an optical use, for example, for a touch panel.

Patent Document 1 has proposed, for example, a transparent conductive film in which a transparent oxide thin film, a silver-based thin film, and a transparent oxide thin film are formed on a glass substrate. In the transparent conductive film of Patent Document 1, the two layers transparent oxide conductive film are both formed from an oxide mixture including indium oxide.

In Patent Document 1, to form a pattern of the transparent conductive film, first, an electrode-formed regist film is formed on the upper side transparent oxide thin film, and then the portion exposed from the regist film is subjected to etching with an etching solution to form the three layer thin film into an electrode form.

Patent Document 2 discloses a light transmitting film, wherein a PET film is coated with an inorganic layer, which comprises, in this order, an indium oxide thin film, a silver thin film, and an indium oxide thin film. In the indium oxide thin films the ratio between the number of hydrogen atoms and the number of metal atoms is between 0.05 and 0.45.

### Citation List

### Patent Document

Patent Document 1
   Japanese Unexamined Patent Publication No.H9-176837
Patent Document 2
   Japanese Patent Application JP 2001 047549 A

### [SUMMARY OF THE INVENTION]

### PROBLEM TO BE SOLVED BY THE INVENTION

However, when the etching speeds of the two layer transparent oxide conductive film in the etching solution are very different, that is, of the two layer transparent oxide conductive film, when the etching speed for the one layer of the transparent oxide conductive film is significantly faster than the other, and when the etching time is set so that patterning is completed on the other transparent oxide conductive film, in the one transparent oxide conductive film, an over etched portion (or side etched portion) that is eroded from its end edge toward the inside to the end edge of the resist film is formed. In such a case, disadvantages such as the following occur: the transparent conductive film hardly keeps its shape, and furthermore, expected effects (e.g., conductive effects) cannot be ensured.

In contrast, when the etching time of the transparent conductive film is set so that patterning of the one transparent conductive film is completed, patterning for the other transparent conductive film cannot be completed based on its significantly slow etching speed. That is, there is a disadvantage in that the other transparent oxide conductive film cannot be patterned into a desired shape.

An object of the present invention is to provide a light transmitting film in which patterns of both of a first inorganic oxide layer and a second inorganic oxide layer can be reliably formed by etching, and formation of an over etched portion is suppressed.

### MEANS FOR SOLVING THE PROBLEM

A light transmitting film of the present invention includes, a transparent substrate and a light transmitting inorganic layer in this order, wherein the transparent substrate is composed of a polymer film, the light transmitting inorganic layer includes, in this order, a first inorganic oxide layer, a metal layer, and a second inorganic oxide layer, so that the second inorganic oxide layer is the uppermost layer of the light transmitting inorganic layer, the light transmitting inorganic layer has conductivity, the first inorganic oxide layer and the second inorganic oxide layer contain hydrogen atoms, the ratio of the hydrogen atom content H2 of the second inorganic oxide layer relative to the hydrogen atom content H1 of the first inorganic oxide layer (H2/H1) is 0.10 or more and 10.00 or less, and the first inorganic oxide layer contains, as a main component, inorganic oxide, wherein the inorganic oxide includes metal oxide formed from at least one metal selected from the group consisting of In, Sn, Zn, Ga, Sb, Ti, Si, Zr, Mg, Al, Au, Ag, Cu, Pd, and W, and the second inorganic oxide layer includes metal oxide formed from at least one metal selected from the group consisting of In, Sn, Zn, Ga, Sb, Ti, Si, Zr, Mg, Al, Au, Ag, Cu, Pd and W; wherein the first inorganic oxide layer and the second inorganic oxide layer further contain carbon atoms, and a total content of the hydrogen atom content H1 and the carbon atom content C1 of the first inorganic oxide layer (H1 + C1), and a total content of the hydrogen atom content H2 and the carbon atom content C2 of the second inorganic oxide layer (H2 + C2) are both 6 × 10¹⁹ atoms/cm³ or more and 10,000 × 10¹⁹ atoms/cm³ or less; and wherein the hydrogen atom content and the carbon atom content (H1, H2, Cl, and C2) are measured using Secondary Mass Spectrometry as described further below.

In the light transmitting film of the present invention, it is preferable that the hydrogen atom content H1 of the first inorganic oxide layer and the hydrogen atom content H2 of the second inorganic oxide layer are both 5 × 10¹⁹atoms/cm³ or more and 8,000 × 10¹⁹atoms/cm³ or less.

In the light transmitting film of the present invention, it is preferable that at least one of the first inorganic oxide layer and the second inorganic oxide layer contains indium oxide.

In the light transmitting film of the present invention, it is preferable that both of the first inorganic oxide layer and the second inorganic oxide layer are amorphous.

In the light transmitting film of the present invention, it is preferable that the ratio of the thickness T2 of the second inorganic oxide layer relative to the thickness T1 of the first inorganic oxide layer (T2/T1) is 0.5 or more and 1.5 or less.

### EFFECT OF THE INVENTION

The light transmitting film of the present invention allows for reliable patterning of both of the first inorganic oxide layer and the second inorganic oxide layer by etching, and suppresses formation of an over etched portion.

### BRIEF DESCRIPTION OF THE DRAWINGS

FIG. 1 shows a cross-sectional view of a light transmitting film of the present invention in an embodiment.
FIG. 2 shows a cross-sectional view of a light transmitting film shown in FIG. 1, in which the light transmitting inorganic layer is formed into a wiring pattern.
FIG. 3 shows an example of a cross-sectional view of the light transmitting film of Comparative Example 1, in which a light transmitting inorganic layer is formed into a wiring pattern, an over etched portion is formed in the first inorganic oxide layer.
FIG. 4 shows an example of a cross-sectional view of a light transmitting film corresponding to Comparative Example, in which the light transmitting inorganic layer is formed into a wiring pattern, and an over etched portion is formed in the second inorganic oxide layer.
FIG. 5 shows a cross-sectional view of a light transmitting film, which is a modified example of the light transmitting film, and in which a first inorganic oxide layer is directly disposed on an upper face of the transparent substrate.
FIG. 6 shows a cross-sectional view of a light transmitting film, which is a modified example of the light transmitting film, and in which the inorganic substance layer is interposed between the protection layer and the first inorganic oxide layer.

### [DESCRIPTION OF EMBODIMENTS]

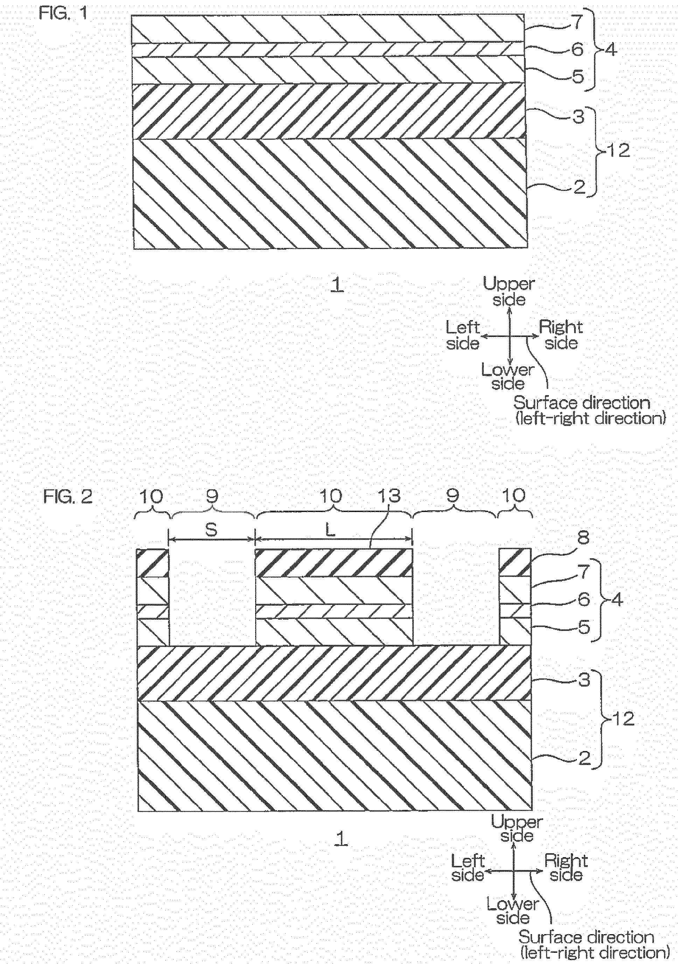

In FIG. 1, up-down direction on the plane of the sheet is referred to as up-down direction (thickness direction, first direction), upper side on the plane of the sheet is referred to as upper side (one side in the thickness direction, one side in the first direction), lower side on the plane of the sheet is referred to as lower side (the other side in the thickness direction, the other side in the first direction). In FIG. 1, left-right directions on the plane of the sheet is referred to as left-right directions (width direction, second direction perpendicular to first direction), left side on the plane of the sheet is left side (one side in the second direction), right side on the plane of the sheet is right side (the other side in the second direction). In FIG. 1, paper thickness direction is referred to as front-back directions (third direction perpendicular to first direction and second direction), and near side on the plane of the sheet is front side (one side in the third direction), and further side on the plane of the sheet is rear side (the other side in the third direction). To be specific, the directions are in conformity with the direction arrows in the figures.

### 1. Light transmitting film

A light transmitting film 1 is in a film form (sheet form) having a predetermined thickness, extends in a predetermined direction (front-back directions and left-right directions, that is, surface direction) perpendicular to the thickness direction, and has a flat top face and a flat lower face (two main faces). The light transmitting film 1 is a component such as a touch panel substrate and a lighting control panel included in, for example, an optical device (e.g., image display device, lighting control device (dimmer)), that is, the light transmitting film 1 is not an optical device. That is, the light transmitting film 1 is a component for producing an optical device, does not include an image display element such as an LCD module, and a light source such as an LED, distributed as a sole component, and is an industrially applicable device. The light transmitting film 1 includes a transparent conductive film.

To be specific, as shown in FIG. 1, the light transmitting film 1 is a light transmitting laminate film including, in this order, a transparent substrate 2, a protection layer 3, and a light transmitting inorganic layer 4. That is, the light transmitting film 1 includes the transparent substrate 2, the protection layer 3 disposed on the upper side of the transparent substrate 2, and the light transmitting inorganic layer 4 disposed on the upper side of the protection layer 3. Preferably, the light transmitting film 1 is composed only of the transparent substrate 2, the protection layer 3, and the light transmitting inorganic layer 4. The layers are described in the following.

### 2. Transparent substrate

The transparent substrate 2 is the lowermost layer of the light transmitting film 1, and is a support material that ensures mechanical strength of the light transmitting film 1. The transparent substrate 2 supports the light transmitting inorganic layer 4 along with the protection layer 3.

The transparent substrate 2 is composed of a polymer film.

The polymer film has transparency. Examples of materials for the polymer film include polyester resins such as polyethylene terephthalate (PET), polybutylene terephthalate, and polyethylenenaphthalate; (meth) acrylic resin (acrylic resin and/or methacrylic resin) such as polymethacrylate; olefin resins such as polyethylene, polypropylene, and cycloolefin polymer; polycarbonate resin; polyether sulfone resin; polyarylate resin; melamine resin; polyamide resin; polyimide resin; cellulose resin; polystyrene resin; and norbornane resin. These polymer films may be used singly, or may be used in a combination of two or more. In view of transparency, heat resistance, and mechanical properties, preferably, olefin resin and polyester resin are used, more preferably, cycloolefin polymer and PET are used.

The transparent substrate 2 has a thickness of, for example, 2 µm or more, preferably 20 µm or more, and for example, 300 µm or less, preferably 200 µm or less, more preferably 150 µm or less.

The transparent substrate 2 preferably contains water, in view of keeping the amorphism of the first inorganic oxide layer 5 and the second inorganic oxide layer 7. That is, in the transparent substrate 2, the polymer film contains water.

### 3. Protection layer

The protection layer 3 is an abrasion protection layer for avoiding abrasions on the top face of the light transmitting inorganic layer 4 (that is, achieving excellent abrasion resistance). The protection layer 3 is an optical adjustment layer that adjusts, as shown in FIG. 2, optical properties of the light transmitting film 1 so that differences between the non-pattern portion 9 and the pattern portion 10 are not recognized (that is, suppress visibility of the wiring pattern) after the light transmitting inorganic layer 4 is formed into a wiring pattern in later step.

The protection layer 3 has a film form (including sheet form), and is disposed on the entire top face of the transparent substrate 2 so as to contact the top face of the transparent substrate 2.

The protection layer 3 is prepared from a resin composition.

The resin composition contains, for example, resin and particles. The resin composition preferably contains only resin, more preferably, composed only of resin.

Examples of the resin include curable resin and thermoplastic resin (e.g., polyolefin resin), preferably, curable resin is used.

Examples of the curable resin include active energy ray curable resin that is cured by irradiation of active energy ray (to be specific, ultraviolet ray, electron beam, etc.) and thermosetting resin that is cured by heat, and preferably, active energy ray curable resin is used.

For the active energy ray curable resin, for example, a polymer having a functional group with a polymerizable carbon-carbon double bond in the molecule is used. Examples of the functional group include a vinyl group and a (meth) acryloyl group (methacryloyl group and/or acryloyl group).

Examples of the active energy ray curable resin include (meth) acrylic resin (acrylic resin and/or methacryl resin) having a functional group in its side chain.

These resins may be used singly, or may be used in combination of two or more.

Examples of the particles include inorganic particles and organic particles. Examples of the inorganic particles include silica particles; metal oxide particles composed of, for example, zirconium oxide and titanium oxide; and carbonate particles such as calcium carbonate. Examples of the organic particles include crosslinking acrylic resin particles.

The protection layer 3 has a thickness of, for example, 0.1 µm or more, preferably 1 µm or more, and for example, 10 µm or less, preferably 5 µm or less. The thickness of the protection layer 3 is measured by, for example, observation of cross sections with a transmission electron microscope (TEM).

### 4. Light transmitting inorganic layer

The light transmitting inorganic layer 4 is a conductive layer for forming a pattern portion 10, as shown in FIG. 2, to be formed into a wiring pattern in a later step. The light transmitting inorganic layer 4 includes a transparent conductive layer.

As shown in FIG. 1, the light transmitting inorganic layer 4 is the uppermost layer of the light transmitting film 1, has a film form (including sheet form), and is disposed on the entire top face of the protection layer 3 so as to contact the top face of the protection layer 3.

The light transmitting inorganic layer 4 includes, in this order, a first inorganic oxide layer 5, a metal layer 6, and a second inorganic oxide layer 7. That is, the light transmitting inorganic layer 4 includes the first inorganic oxide layer 5 disposed on the protection layer 3, the metal layer 6 disposed on the first inorganic oxide layer 5, and the second inorganic oxide layer 7 disposed on the metal layer 6. The light transmitting inorganic layer 4 preferably is composed only of the first inorganic oxide layer 5, the metal layer 6, and the second inorganic oxide layer 7.

### 5. First inorganic oxide layer

The first inorganic oxide layer 5 is a conductive layer imparting conductivity to the light transmitting inorganic layer 4 along with the metal layer 6 and the second inorganic oxide layer 7 described later. The first inorganic oxide layer 5 is also a barrier layer that prevents hydrogen derived from water contained in the transparent substrate 2 and carbon derived from organic substance contained in the protection layer 3 from intruding to the metal layer 6. Furthermore, the first inorganic oxide layer 5 is also an optical adjustment layer for improving visible light transmission of the light transmitting inorganic layer 4 along with the second inorganic oxide layer 7 described later, suppressing visible light reflectivity of the metal layer 6.

The first inorganic oxide layer 5 is the lowermost layer of the light transmitting inorganic layer 4, has a film form (including sheet form), and is disposed on the entire top face of the protection layer 3 so as to contact the top face of the protection layer 3.

The first inorganic oxide layer 5 contains, as a main component, inorganic oxide that can be dissolved in an etching solution described later.

According to the present invention, the inorganic oxide includes metal oxide formed from at least one metal selected from the group consisting of In, Sn, Zn, Ga, Sb, Ti, Si, Zr, Mg, Al, Au, Ag, Cu, Pd, and W. To the metal oxide, as necessary, the metal atom of the above-described group can be doped.

For the inorganic oxide, preferably, indium oxide-containing oxide is used in view of reducing specific resistance and ensuring excellent transparency, and more preferably, indium-tin composite oxide (ITO) is used.

The tin oxide (SnO₂) content in the ITO relative to a total amount of tin oxide and indium oxide (In₂O₃) is, for example, 0.5 mass% or more, preferably 3 mass% or more, more preferably 6 mass% or more, further preferably 8 mass% or more, particularly preferably 10 mass% or more, most preferably more than 10 mass%, and for example, 35 mass% or less, preferably 20 mass% or less, more preferably 15 mass% or less, further preferably 13 mass% or less. The indium oxide content (In₂O₃) is the remaining portion of the tin oxide (SnO₂) content. By setting the tin oxide (SnO₂) content of the ITO in a suitable range, the changes in the quality of the film over time of the ITO film can be easily suppressed.

The inorganic oxide can be any of crystalline or amorphous. The inorganic oxide is, preferably, amorphous, as shown in FIG. 2, in view of easily conducting patterning in a later step.

In the present application, when the crystal grain occupies the area percentage of 50% or less (preferably 0% or more and 30% or less), it is considered amorphous, and when the crystal grain occupies the area percentage of more than 50% (preferably 80% or more), it is considered crystalline in a plane TEM image magnitude of 25,000.

The first inorganic oxide layer 5 has an inorganic oxide content of, for example, 95 mass% or more, preferably 98 mass% or more, and preferably 99 mass% or more, and for example, less than 100 mass%.

The first inorganic oxide layer 5 contains hydrogen atoms. The hydrogen atom is not derived from, for example, the inorganic oxide contained as a main component in the first inorganic oxide layer 5, but is derived from water (H₂O) contained in the polymer film of the transparent substrate 2 or water (H₂O) adsorbed in a dry device (to be specific, vacuum device such as sputtering device) (to be described in detail in production method later).

The first inorganic oxide layer 5 has a hydrogen atom content H1 of, for example, 5 × 10¹⁹atoms/cm³ or more, preferably 10 × 10¹⁹atoms/cm³ or more, more preferably 50 × 10¹⁹atoms/cm³ or more, further preferably 100 × 10¹⁹atoms/cm³ or more, and for example, 8,000 × 10¹⁹atoms/cm³ or less, preferably 4,000 × 10¹⁹atoms/cm³ or less, more preferably 800 × 10¹⁹atoms/cm³ or less.

When the first inorganic oxide layer 5 has a hydrogen atom content H1 of the above-described upper limit or less, film quality deterioration of the first inorganic oxide layer 5 under humid and hot environment can be prevented.

Meanwhile, when the first inorganic oxide layer 5 has a hydrogen atom content H1 of the above-described lower limit or more, crystallization over time of the first inorganic oxide layer 5 can be suppressed, and excellent etching properties can be kept.

Furthermore, the first inorganic oxide layer 5 contains carbon atoms. The carbon atom is not derived from, for example, the above-described inorganic oxide, but is derived from the organic substance contained in the above-described protection layer 3.

According to the present invention, the carbon atom content C1 of the first inorganic oxide layer 5 is adjusted so that a total of the hydrogen atom content H1 and the carbon atom content C1 in the first inorganic oxide layer 5 (H1 + C1) is 6 × 10¹⁹atoms/cm³ or more, preferably 10 × 10¹⁹atoms/cm³ or more, more preferably 20 × 10¹⁹atoms/cm³ or more, further preferably 100 × 10¹⁹atoms/cm³ or more, and 10,000 × 10¹⁹atoms/cm³ or less, preferably 5,000 × 10¹⁹atoms/cm³ or less, more preferably 1,000 × 10¹⁹atoms/cm³ or less.

When the total content of H1 + C1 is the above-described upper limit or less, a first inorganic oxide layer with excellent humidity and heat durability can be produced.

Meanwhile, when the total content of H1 + C1 is the above-described lower limit or more, etching properties of the first inorganic oxide layer 5 can be improved.

To be specific, the first inorganic oxide layer 5 has a carbon atom content C1 of, for example, 1 × 10¹⁹atoms/cm³ or more, preferably 3 × 10¹⁹atoms/cm³ or more, more preferably 10 × 10¹⁹atoms/cm³ or more, and for example, 100 × 10¹⁹atoms/cm³ or less, preferably 50 × 10¹⁹atoms/cm³ or less, more preferably 30 × 10¹⁹atoms/cm³ or less. The carbon atom content C1 of the first inorganic oxide layer 5 is measured by subjecting a center portion in the thickness direction of the first inorganic oxide layer 5 to Secondary Ion Mass Spectrometry.

The first inorganic oxide layer 5 has a thickness T1 of, for example, 5 nm or more, preferably 20 nm or more, more preferably 30 nm or more, and for example, 60 nm or less, preferably 50 nm or less. When the first inorganic oxide layer 5 has thickness T1 in the above-described range, visible light transmission of the light transmitting inorganic layer 4 can be easily adjusted to a high level. The thickness T1 of the first inorganic oxide layer 5 is measured, for example, by cross sectional observation with a transmission electron microscope (TEM).

### 6. Metal layer

The metal layer 6 is a conductive layer that imparts conductivity to the light transmitting inorganic layer 4, along with the first inorganic oxide layer 5 and the second inorganic oxide layer 7. The metal layer 6 is also a low specific resistance layer that reduces the specific resistance of the light transmitting inorganic layer 4.

The metal layer 6 has a film form (including sheet form), and is disposed at the top face of the first inorganic oxide layer 5 so as to contact the top face of the first inorganic oxide layer 5.

Metal that forms the metal layer 6 is, for example, metal that has a low specific resistance, and can be dissolved in the same etching solution that is used for etching the first inorganic oxide layer 5. The metal material is not limited, and examples thereof include a metal selected from the group consisting of Ti, Si, Nb, In, Zn, Sn, Au, Ag, Cu, Al, Co, Cr, Ni, Pb, Pd, Pt, Cu, Ge, Ru, Nd, Mg, Ca, Na, W, Zr, Ta, and Hf, and an alloy containing two or more metals thereof.

For the metal, preferably, silver (Ag) and a silver alloy are used, and more preferably, a silver alloy is used. When the metal is silver or a silver alloy, not only the resistance value of the light transmitting inorganic layer 4 can be made small, a light transmitting inorganic layer 4 with a significantly high average reflectance for near-infrared ray region (wavelength 850 to 250 nm) can be produced, which can be suitably used for image display device for outdoor use.

The silver alloy contains silver as a main component, and contains other metal as a sub component. To be specific, examples thereof include an Ag-Pd alloy, Ag-Pd-Cu alloy, Ag-Pd-Cu-Ge alloy, Ag-Cu-Au alloy, Ag-Cu-Sn alloy, Ag-Ru-Cu alloy, Ag-Ru-Au alloy, Ag-Nd alloy, Ag-Mg alloy, Ag-Ca alloy, and Ag-Na alloy. In view of humidity and heat durability, a silver alloy, preferably a Cu-containing Ag alloy (e.g., Ag-Cu alloy, Ag-Cu-Sn alloy, etc.), Pd-containing Ag (e.g., Ag-Pd alloy, etc.) alloy, and Cu, Pd-containing Ag alloy (e.g., Ag-Pd-Cu alloy, etc.) are used.

The silver alloy (preferably, Ag-Pd alloy) has a silver content of, for example, 80 mass% or more, preferably 90 mass% or more, more preferably 95 mass% or more, and for example, 99.9 mass% or less. The content of the other metal in the silver alloy is the remaining portion of the above-described silver content. When the metal is an Ag-Pd alloy, the Ag-Pd alloy has a Pd content of, to be specific, for example, 0.1 mass% or more, and for example, 10 mass% or less, preferably 5 mass% or less, more preferably 1 mass% or less.

The metal layer 6 has a thickness of, in view of improving transmissivity of the light transmitting inorganic layer 4, for example, 1 nm or more, preferably 5 nm or more, and for example, 20 nm or less, preferably 10 nm or less.

### 7. Second inorganic oxide layer

The second inorganic oxide layer 7 is a conductive layer that imparts conductivity to the light transmitting inorganic layer 4, along with the first inorganic oxide layer 5 and the metal layer 6. The second inorganic oxide layer 7 is also a barrier layer that prevents intrusion of oxygen and water content in the environment to the metal layer 6, and also is an optical adjustment layer for suppressing visible light reflectivity of the metal layer 6, and improving visible light transmission of the light transmitting inorganic layer 4.

The second inorganic oxide layer 7 is the uppermost layer of the light transmitting inorganic layer 4, has a film form (including sheet form), and is disposed at the entire top face of the metal layer 6 so as to contact the top face of the metal layer 6.

According to the present invention, the second inorganic oxide layer 7 contains inorganic oxide given for the first inorganic oxide layer 5. To be specific, the second inorganic oxide layer 7 is inorganic oxide that can be dissolved in the same etching solution for etching the first inorganic oxide layer 5, and preferably contains indium oxide. More preferably, the second inorganic oxide layer 7 is composed of ITO.

The second inorganic oxide layer 7 has an inorganic oxide content of, for example, 95 mass% or more, preferably 98 mass% or more, more preferably 99 mass% or more, and for example, less than 100 mass%.

The second inorganic oxide layer 7 contains hydrogen atoms. The hydrogen atom is not derived from inorganic oxide contained, for example, as the main component in the second inorganic oxide layer 7, but is derived from water (H₂O) contained in the polymer film of the transparent substrate 2 or water (H₂O) adsorbed in a dry device (to be specific, vacuum device such as a sputtering device) (to be described in detail in production method later).

The hydrogen atom content H2 of the second inorganic oxide layer 7 is set so that the ratio of the hydrogen atom content H2 of the second inorganic oxide layer 7 relative to the hydrogen atom content H1 of the first inorganic oxide layer 5 (H2/H1) is 0.10 or more, and 10.00 or less.

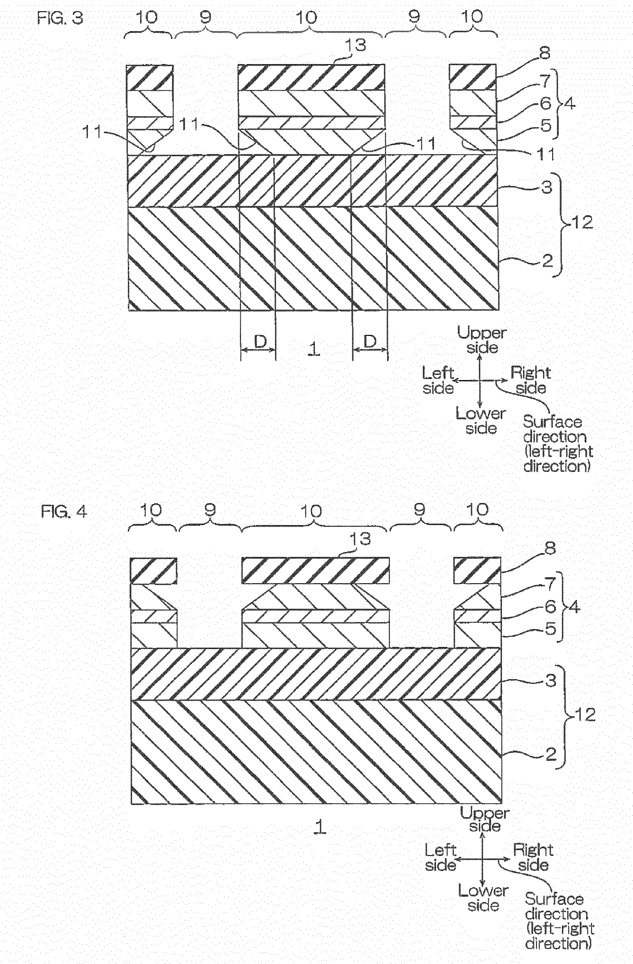

Meanwhile, when the hydrogen atom ratio (H2/H 1) is less than 0.10, the hydrogen atom content H1 of the first inorganic oxide layer 5 relative to the hydrogen atom content H2 of the second inorganic oxide layer 7 is excessively high. Therefore, in etching for the light transmitting inorganic layer 4 described later, the etching speed R1 of the first inorganic oxide layer 5 in the etching solution relative to the etching speed R2 of the etching solution of the second inorganic oxide layer 7 is excessively fast. As a result, as shown in FIG. 3, in etching of the light transmitting inorganic layer 4, an over etched portion 11 is formed at the end portion of the first inorganic oxide layer 5.

As shown in FIG. 3, the over etched portion 11 has a generally triangular shape when viewed in cross section. However, the shape of the over etched portion 11 is not limited to the one shown in FIG. 3. For example, although not shown, the cross section of the both end portions of the over etched first inorganic oxide layer 5 can be vertical to the surface direction of the metal layer 6.

Meanwhile, when the ratio (H2/H1) is more than 10.00, the hydrogen atom content H2 of the second inorganic oxide layer 7 relative to the hydrogen atom content H1 of the first inorganic oxide layer 5 is excessively high. Therefore, in etching of the light transmitting inorganic layer 4, the etching speed R2 of the second inorganic oxide layer 7 in the etching solution relative to the etching speed R1 of the first inorganic oxide layer 5 in the etching solution is excessively fast. As a result, as shown in FIG. 4, in etching of the light transmitting inorganic layer 4, an over etched portion 11 is formed at the end portion of the second inorganic oxide layer 7.

The hydrogen atom content H2 of the second inorganic oxide layer 7 is set so that the hydrogen atom content H2 of the second inorganic oxide layer 7 relative to the hydrogen atom content H1 of the first inorganic oxide layer 5 (H2/H1) is preferably 0.20 or more, more preferably 0.40 or more, further preferably 0.50 or more, further preferably 0.75 or more, and preferably 5.00 or less, more preferably 2.50 or less, further preferably 1.50 or less, particularly preferably 1.25 or less, most preferably 1.20 or less.

When the ratio (H2/H1) is the above-described lower limit or more, when etching the light transmitting inorganic layer 4, formation of the over etched portion 11 at the end portion of the first inorganic oxide layer 5 can be suppressed.

Meanwhile, when the ratio (H2/H1) is the above-described upper limit or less, when etching the light transmitting inorganic layer 4, formation of the over etched portion 11 at the end portion of the second inorganic oxide layer 7 can be suppressed.

That is, the ratio (H2/H1) of the above-described lower limit or more, and the above-described upper limit or less allows for approximation of the etching speed R1 of the first inorganic oxide layer 5 in the etching solution to the etching speed R2 of the second inorganic oxide layer 7 in the etching solution. Therefore, formation of the over etched portion 11 at any of the first inorganic oxide layer 5 and the second inorganic oxide layer 7 can be suppressed.

The ratio of the hydrogen atom content H2 of the second inorganic oxide layer 7 relative to the hydrogen atom content H1 of the first inorganic oxide layer 5 (H2/H1) is adjusted in the production method of the first inorganic oxide layer 5 and the second inorganic oxide layer 7 described later.

To be specific, the second inorganic oxide layer 7 has a hydrogen atom content H2 of, for example, 5 × 10¹⁹atoms/cm³ or more, preferably 10 × 10¹⁹atoms/cm³ or more, preferably 100 × 10¹⁹atoms/cm³ or more, and for example, 8,000 × 10¹⁹atoms/cm³ or less, preferably 4,000 × 10¹⁹atoms/cm³ or less, more preferably 800 × 10¹⁹atoms/cm³ or less, further preferably 300 × 10¹⁹atoms/cm³ or less.

When the hydrogen atom content H2 of the second inorganic oxide layer 7 is the above-described upper limit or less, the film quality deterioration of the second inorganic oxide layer 7 under humid and hot environment can be prevented. When the hydrogen atom content H2 of the second inorganic oxide layer 7 is the above-described lower limit or more, crystallization over time of the second inorganic oxide layer 7 can be suppressed, and excellent etching properties can be kept.

The hydrogen atom content H2 of the second inorganic oxide layer 7 is measured by subjecting a center portion in the thickness direction of the second inorganic oxide layer 7 to Secondary Ion Mass Spectrometry.

The second inorganic oxide layer 7 further contains carbon atoms. The carbon atom is not derived from, for example, the above-described inorganic oxide, but is derived from the organic substance (described in detail in production method later) contained in the polymer film of the above-described transparent substrate 2.

According to the present invention, the carbon atom content C2 of the second inorganic oxide layer 7 is adjusted so that a total content of the hydrogen atom content H2 and the carbon atom content C2 of the second inorganic oxide layer 7 (H2 + C2) is 6 × 10¹⁹atoms/cm³ or more, preferably 10 × 10¹⁹atoms/cm³ or more, more preferably 20 × 10¹⁹atoms/cm³ or more, further preferably 100 × 10¹⁹atoms/cm³ or more, and 10,000 × 10¹⁹atoms/cm³ or less, preferably 5,000 × 10¹⁹atoms/cm³ or less, more preferably 1,000 × 10¹⁹atoms/cm³ or less.

When the total content (H2 + C2) is the above-described upper limit or less, a second inorganic oxide layer 7 with excellent humidity and heat durability can be produced. When the total content (H2 + C2) is the above-described lower limit or more, a second inorganic oxide layer 7 with excellent etching properties can be produced.

To be specific, the second inorganic oxide layer 7 has a carbon atom content C2 of, for example, 1 × 10¹⁹atoms/cm³ or more, preferably 2 × 10¹⁹atoms/cm³ or more, more preferably 3 × 10¹⁹atoms/cm³ or more, and for example, 100 × 10¹⁹atoms/cm³ or less, preferably 50 × 10¹⁹atoms/cm³ or less, more preferably 30 × 10¹⁹atoms/cm³ or less, further preferably 10 × 10¹⁹atoms/cm³ or less.

As to the ratio "(H2 + C2)/(H1 + C1)", or the total content of the hydrogen atom content H2 and the carbon atom content C2 of the second inorganic oxide layer 7 (H2 + C2) relative to the total content of the hydrogen atom content H1 and the carbon atom content C1 of the first inorganic oxide layer 5 (H1 + C1), (H2 + C2)/(H 1 + C1) is preferably higher than the hydrogen atom ratio (H2/H1). The value for {(H2 + C2)/(H1 + C1)}/(H2/H1) is, for example, 1.01 or more, preferably 1.03 or more, and for example, 3.00 or less, preferably 2.00 or less, more preferably 1.50 or less. The second inorganic oxide layer 7 disposed at the side contacting the air is prone to be a crystal film based on oxygen in the air compared with the first inorganic oxide layer 5, and also by containing a large amount of carbon atoms further in addition to the sufficient amount of hydrogen atoms, the amorphous state is kept and etching properties can be secured. The reasons are not limited by any theory, but it can be assumed that carbon atoms have an atom size larger than hydrogen atoms, and easily hinder crystallization of the inorganic oxide layer. The ratio of the total of the hydrogen atom and carbon atom (H2 + C2)/(H 1 + C1) is larger than the ratio of hydrogen atom (H2/H1), compared with the contrary case, even with a small hydrogen atom content level in the first inorganic oxide layer 5 and second inorganic oxide layer 7 (e.g., about 10 × 10¹⁹atoms/cm³), excellent etching properties can be kept more. Meanwhile, when the value for {(H2 + C2)/(H1 + C1)}/(H2/H1) is excessively large (e.g., the value is more than 3.00), the film quality of the second inorganic oxide layer 7 may deteriorate and humidity and heat durability may deteriorate.

The thickness T2 of the second inorganic oxide layer 7 is adjusted so that the ratio of the thickness T2 of the second inorganic oxide layer relative to the thickness T1 of the first inorganic oxide layer (T2/T1) is, for example, 0.5 or more, preferably 0.75 or more, and for example, 1.5 or less, preferably 1.25 or less.

When the ratio (T2/T1) is the above-described lower limit or more and the above-described upper limit or less, deterioration of the metal layer 6 even under humid and hot environment can be suppressed.

To be specific, the second inorganic oxide layer 7 has a thickness T2 of, for example, 5 nm or more, preferably 20 nm or more, further preferably 30 nm or more, and for example, 60 nm or less, preferably 50 nm or less. When the second inorganic oxide layer 7 has a thickness T2 in the above-described range, visible light transmission of the light transmitting inorganic layer 4 can be adjusted to a high level.

The light transmitting inorganic layer 4 has a thickness, that is, a total thickness of the first inorganic oxide layer 5, metal layer 6 and second inorganic oxide layer 7 is, for example, 20 nm or more, preferably 40 nm or more, more preferably 60 nm or more, further preferably 80 nm or more, and for example, 150 nm or less, preferably 120 nm or less, more preferably 100 nm or less.

### 8. Method for producing a light transmitting film

Next, description is given below of a method for producing a light transmitting film 1.

To produce a light transmitting film 1, for example, a protection layer 3, a first inorganic oxide layer 5, a metal layer 6, and a second inorganic oxide layer 7 are disposed (laminated) on a transparent substrate 2 in the above-described order.

In this method, as shown in FIG. 1, first, the transparent substrate 2 is prepared.

The prepared transparent substrate 2 (polymer film) has a moisture content of, for example, 10µg/cm² or more, preferably 15µg/cm² or more, and for example, 200µg/cm² or less, preferably 170µg/cm² or less. The moisture content of the above-described lower limit or more easily allows for suppression of great change over time of the crystallinity of the first inorganic oxide layer 5 and the second inorganic oxide layer 7 to be formed later. Meanwhile, the moisture content of the above-described upper limit or less easily allows for suppression of a large difference between the hydrogen atom content H2 of the second inorganic oxide layer 7 and the hydrogen atom content H1 of the first inorganic oxide layer 5. The moisture content of the transparent substrate 2 is measured in conformity with JIS K 7251 (2002) method B-water vaporization method.

The transparent substrate 2 (polymer film) has a water content of, for example, 0.05 mass% or more, preferably 0.1 mass% or more, and for example, 1.5 mass% or less, preferably 1.0 mass% or less, more preferably 0.5 mass% or less.

A part or the whole of the above-described water is discharged to the outside in degassing to be described later.

Then, the resin composition is disposed on the top face of the transparent substrate 2 by, for example, wet process.

To be specific, first, the resin composition is applied on the top face of the transparent substrate 2. Thereafter, when the resin composition contains the active energy ray curable resin, active energy ray irradiation is performed.

In this manner, the protection layer 3 in a film form is formed on the entire top face of the transparent substrate 2. That is, a transparent substrate 12 having a transparent substrate 2 and a protection layer 3 is produced (protection layer-provided transparent substrate 12).

The protection layer 3 contains a suitable ratio of an organic substance.

Thereafter, as necessary, the protection layer-provided transparent substrate 12 is subjected to degassing.

To subject the protection layer-provided transparent substrate 12 to degassing, the protection layer-provided transparent substrate 12 is allowed to stand at a reduced pressure atmosphere of, for example, 1 × 10⁻¹ Pa or less, preferably 1 × 10⁻²Pa or less, and for example, 1 × 10⁻³Pa or less, preferably 5 × 10⁻⁴Pa or less. Degassing is performed using an exhauster (to be specific, including turbomolecular pump) included in a dry device to be described in detail later.

The degassing allows a portion of water contained in the transparent substrate 2 and a portion of the organic substance contained in the protection layer 3 to the outside.

Then, the light transmitting inorganic layer 4 is disposed on the top face of the protection layer 3 by, for example, dry process.

To be specific, the first inorganic oxide layer 5, the metal layer 6, and the second inorganic oxide layer 7 are disposed, in this order, by dry process.

Examples of the dry process include vacuum deposition, sputtering, and ion plating. Preferably, sputtering is used. To be specific, magnetron sputtering is used.

Examples of the gas used in sputtering include inert gas such as Ar. As necessary, reactive gas such as oxygen is used in combination. When reactive gas is used in combination, the flow rate ratio of the reactive gas is not particularly limited, and is a ratio of the reactive gas flow rate relative to the inert gas flow rate, and is, for example, 0.1/100 or more, preferably 1/100 or more, and for example, 5/100 or less.

For the gas, to be specific, in formation of the first inorganic oxide layer 5, preferably inert gas and reactive gas are used in combination. For the formation of the metal layer 6, gas, preferably inert gas is used singly. For the formation of the second inorganic oxide layer 7, gas, preferably inert gas and reactive gas are used in combination.

The power source used in sputtering is not limited, and for example, any of DC power source, MF/AC power source, and RF power source can be used, and these can be combined as well.

Preferably, when the first inorganic oxide layer 5 is formed by sputtering, the transparent substrate 2 (and the protection layer 3) is cooled. To be specific, the lower face (that is, the face opposite to the face where the first inorganic oxide layer 5 is formed in the transparent substrate 2 (that is, the top face of the transparent substrate 2) in the transparent substrate 2) of the transparent substrate 2 is allowed to contact, for example, a cooling device (e.g., chill roll) to cool the transparent substrate 2 (and the protection layer 3). In this manner, when forming the first inorganic oxide layer 5, heat from vapor deposition caused in sputtering allows the water contained in the transparent substrate 2 and the organic substance contained in the protection layer 3 are discharged in a large amount, thus excessive water content in the first inorganic oxide layer 5 can be suppressed. Cooling temperature is, for example, -30°C or more, preferably, -10°C or more, and for example, 60°C or less, preferably 40°C or less, more preferably 20°C or less.

In this manner, the light transmitting inorganic layer 4 in which the first inorganic oxide layer 5, metal layer 6, and second inorganic oxide layer 7 are formed in order is formed on the protection layer 3.

The light transmitting inorganic layer 4 has a surface resistance value of, for example, 40Ω/□or less, preferably 30Ω/□or less, more preferably 20Ω/□or less, even more preferably 15Ω/□or less, and for example, 0.1Ω/□ or more, preferably 1Ω/□ or more, more preferably 5Ω/□ or more.

The light transmitting inorganic layer 4 has a specific resistance of, for example, 2.5 × 10⁻⁴Ω·cm or less, preferably 2.0 × 10⁻⁴Ω·cm or less, more preferably 1.5 × 10⁻⁴Ω·cm or less, further preferably 1.1 × 10⁻⁴Ω·cm or less, and for example, 0.01 × 10⁻⁴Ω·cm or more, preferably 0.1 × 10⁻⁴Ω·cm or more, more preferably 0.5 × 10⁻⁴Ω·cm or more.

The specific resistance of the light transmitting inorganic layer 4 is calculated by using the thickness (total thickness of the first inorganic oxide layer, metal layer 6, second inorganic oxide layer 7) and the surface resistance values of the light transmitting inorganic layer 4.

The light transmitting inorganic layer 4 preferably has a high average reflectivity for near infrared ray (wavelength 850 to 2500 nm). The light transmitting inorganic layer 4 including a metal layer 6 (e.g., metal layer 6 including silver or silver alloy) having a high reflectivity for near infrared ray region has an average reflectivity for near infrared ray compared with, for example, a transparent inorganic oxide composed of conductive oxide (e.g., ITO, etc.), and can efficiently shut out heat rays such as sunlight. Therefore, it can be suitably used for an image display device used under an environment (e.g., outdoor, etc.) in which the panel temperature easily increase as well. The light transmitting inorganic layer 4 has an average reflectivity for near infrared ray (wavelength 850 to 2500 nm) of, for example, 10% or more, preferably 20% or more, more preferably 40% or more, further preferably 50% or more, and for example, 95% or less, preferably 90% or less.

The ratio of the hydrogen atom content H2 of the second inorganic oxide layer 7 relative to the hydrogen atom content H1 of the first inorganic oxide layer 5 (H2/H1) can be set to the above-described range by any method without limitation, but preferably at least one of the following of (1) to (2) is selected.

(1) Water (water vapor) is introduced in the atmosphere of the dry process device when forming the first inorganic oxide layer 5 and the second inorganic oxide layer 7 by dry process. The water can be introduced by any method, but for example, water can be introduced by gas mixture of water vapor and inert gas prepared by allowing inert gas to pass through a distilled water storage tank disposed outside the device can be introduced in the dry process device. Water can be introduced in this manner easily. Furthermore, a plurality of gas introduction paths can be provided to introduce a gas mixture of water vapor and inert gas and an inert gas (gas containing no water vapor) through separate routes, and introduction rates can be suitably changed. Water can be introduced in an amount of, at the time of forming the first inorganic oxide layer 5 and the second inorganic oxide layer 7, in a ratio of water vapor flow rate relative to the inert gas flow rate, for example, 0.01/100 or more, preferably 0.1/100 or more, more preferably 0.5/100 or more, even more preferably 1/100 or more, and for example 20/100 or less, more preferably 10/100 or less. When the gas mixture of water vapor and inert gas and an inert gas are introduced through separate routes, the amount of water introduced at the time of forming the first inorganic oxide layer 5 and the second inorganic oxide layer 7 is, in a flow rate of gas mixture of water vapor and inert gas relative to the inert gas flow rate, for example, 1/100 or more, preferably 10/100 or more, more preferably 15/100 or more, and for example, 80/100 or less, 50/100 or less. Preferably, the amount of water introduced at the time of forming is large in the second inorganic oxide layer 7 compared with the first inorganic oxide layer 5, and the ratio of the amount of water introduced at the time of forming the second inorganic oxide layer 7 relative to the amount of water introduced at the time of forming the first inorganic oxide layer 5 (water introduction amount at the time of forming the second inorganic oxide layer 7/water introduction amount at the time of forming the first inorganic oxide layer 5) is, for example, 110/100 or more, preferably 120/100 or more, more preferably 150/100 or more.
   With the process of (1), the hydrogen atom content H1 of the first inorganic oxide layer 5 and the hydrogen atom content H2 of the second inorganic oxide layer 7 can be easily adjusted.
(2)The time when the formation of the light transmitting inorganic layer 4 is started and completed, to be specific, the time of the start of the formation of the first inorganic oxide layer 5 and to the completion of the formation of the second inorganic oxide layer 7 is set to be a short period of time, to be specific, for example, 15 minutes or less, preferably 10 minutes or less, more preferably 5 minutes or less, more preferably 3 minutes or less, and for example, 5 seconds or more, preferably 30 seconds or more.

At the time of forming the first inorganic oxide layer 5 and the second inorganic oxide layer 7 by dry process, the gas component (to be specific, water, etc.) derived from the transparent substrate 2 decreases over time under vacuum (reduced pressure) environment. Then, when the second inorganic oxide layer 7 is formed by dry process, the water content of the second inorganic oxide layer 7 is significantly reduced over time under vacuum (reduced pressure) atmosphere. Therefore, with the process of (2), if the formation of the light transmitting inorganic layer 4 is completed in short period of time, reduction of the water content of the second inorganic oxide layer 7 is suppressed, and therefore the hydrogen atom content H2 of the second inorganic oxide layer 7 and the hydrogen atom content H1 of the first inorganic oxide layer 5 are approximated (in other words, difference of H2 and H1 is made small) to approximate H2/H1 to 1.

To set the ratio of the hydrogen atom content H2 of the second inorganic oxide layer 7 to the hydrogen atom content H1 of the first inorganic oxide layer 5 (H2/H1) in the above-described range, preferably, (1) and (2) are used in combination.

As shown in FIG. 1, a light transmitting film 1 including, in this order, the transparent substrate 2, the protection layer 3, the first inorganic oxide layer 5, the metal layer 6, and the second inorganic oxide layer 7 is produced in this manner.

The light transmitting film 1 includes the light transmitting inorganic layer 4 having the optical adjustment layer (first inorganic oxide layer 5 and second inorganic oxide layer 7) on the top face and the lower face of the metal layer 6, and therefore the light transmitting inorganic layer 4 having a high visible light transmission can be achieved even though the metal layer 6 with a generally high visible light reflectivity (to be specific, metal layer 6 having, for example, a reflectance for wavelength 550 nm of 15% or more, furthermore, 30% or more). The light transmitting film 1 has a visible light transmission of, for example, 60% or more, preferably 70% or more, more preferably 80% or more, further preferably 85% or more, most preferably more than 86%, and for example, 95% or less.

The light transmitting film 1 has a total thickness of, for example, 2 µm or more, preferably 20 µm or more, and for example, 300 µm or less, preferably 200 µm or less, more preferably 150 µm or less.

The above-described production method can be performed by roll-to-roll method. A part or entire process can also be performed by batch.

### 9. Patterning of light transmitting inorganic layer

Thereafter, as shown in FIG. 2, the light transmitting inorganic layer 4 is formed into a wiring pattern by etching. In this manner, a non-pattern portion 9 and a pattern portion 10 are formed on the protection layer 3. In the non-pattern portion 9, the top face of the protection layer 3 is exposed from the pattern portion 10.

To be specific, first, a photosensitive film is disposed on the entire top face of the second inorganic oxide layer 7, and then, as shown in FIG. 2, the second inorganic oxide layer 7 is exposed to light through a photo mask having a pattern of the non-pattern portion 9 and the pattern portion 10, and thereafter, developing is performed and the photosensitive film corresponding to the non-pattern portion 9 is removed. In this manner, the etching resist 8 having a pattern that is the same as the pattern portion 10 is formed on the top face of the light transmitting inorganic layer 4 that is to be the pattern portion 10.

Thereafter, the light transmitting inorganic layer 4 exposed from the etching resist 8 is subjected to etching using an etching solution. For the etching solution, any etching solution that is capable of dissolving at least the first inorganic oxide layer 5 and the second inorganic oxide layer 7, preferably, the first inorganic oxide layer 5, the metal layer 6, and the second inorganic oxide layer 7 will suffice without limitation on its composition, and for example, acids such as hydrochloric acid, sulfuric acid, nitric acid, acetic acid, oxalic acid, phosphoric acid, and a mixture thereof can be used. In this manner, the second inorganic oxide layer 7 corresponding to the non-pattern portion 9, the metal layer 6, and the first inorganic oxide layer 5 are removed.

In this manner, as shown in FIG. 2, the light transmitting inorganic layer 4 is formed into a wiring pattern having a stripe shaped pattern portion 10. The pattern portion 10 extends into, for example, front-back directions, and is arranged in line in a plural number in left-right directions with a space provided therebetween (non-pattern portion 9). The width L of the pattern portion 10 is, for example, 1 µm or more and 3000 µm or less. The space S of adjacent pattern portions 10 is, for example, 1 µm or more and 3000 µm or less.

Thereafter, the etching resist 8 is removed from the top face of the second inorganic oxide layer 7 by, for example, peeling.

Thereafter, the light transmitting film 1 is provided, for example, in an optical device.

Examples of the optical device include image display devices and lighting control devices.

When the light transmitting film 1 is provided in an image display device (to be specific, an image display device having an image display element such as LCD module), the light transmitting film 1 is used, for example, as a touch panel substrate. Examples of touch panel system include various systems of optical, ultrasonic, capacitance, and resistive film, and particularly, the present invention is used suitably for capacitance touch panel.

The light transmitting film 1 can also be used, for example, as a substrate for near infrared ray reflection. For example, by providing the image display device with the light transmitting film 1 having a high average reflectivity for near infrared ray of wavelength 850 to 2500 nm (e.g., 10% or more), it can be suitably used for image display devices for outdoor use. The light transmitting film 1 can be included in an image display device as, for example, a light transmitting inorganic layer laminate polarization film by bonding it to a polarization film.

Furthermore, when the light transmitting film 1 is included in the lighting control device (to be specific, a lighting control device having a light source such as LED), the light transmitting film 1 is included, for example, as a lighting control film.

### 10. Operations and effects

With the light transmitting film 1, both of the first inorganic oxide layer 5 and the second inorganic oxide layer 7 can be patterned reliably by etching, while formation of the over etched portion 11 can be suppressed.

That is, because the ratio (H2/H1) is 0.10 or more and 10.00 or less, physical properties (e.g., film quality) of the first inorganic oxide layer 5 can be approximated with those of the second inorganic oxide layer 7. To be specific, the etching speed R1 of the first inorganic oxide layer 5 in the etching solution can be approximated with the etching speed R2 of the second inorganic oxide layer 7 in the etching solution. Therefore, generation of the over etched portion 11 can be suppressed in any of the first inorganic oxide layer 5 and the second inorganic oxide layer 7.

Meanwhile, Japanese Unexamined Patent Publication No. 2003-36037 discloses a silver alloy wiring including a silver alloy conductive layer and a conductive protection layer, and that a side etching portion (over etched portion) is formed in the silver alloy conductive layer based on the difference between the etching speed of the silver alloy conductive layer and the etching speed of the conductive protection layer. However, Japanese Unexamined Patent Publication No. 2003-36037 does not disclose the over etched portion in the first inorganic oxide layer and the second inorganic oxide layer, as described in "PROBLEM TO BE SOLVED BY THE INVENTION" above.

Furthermore, in the light transmitting film 1, when the hydrogen atom content H1 of the first inorganic oxide layer and the hydrogen atom content H2 of the second inorganic oxide layer are both 5 × 10¹⁹atoms/cm³ or more, 8,000 × 10¹⁹atoms/cm³ or less, excellent humidity and heat durability can be kept.

Furthermore, in the light transmitting film 1, of the first inorganic oxide layer 5 and the second inorganic oxide layer 7, when at least one of them contains indium oxide, excellent etching properties and environment resistance can both achieved.

Furthermore, in the light transmitting film 1, when both of the first inorganic oxide layer 5 and the second inorganic oxide layer 7 are amorphous, patterning by etching can be easily conducted.

Furthermore, with the light transmitting metal laminate film 1, when the metal layer 6 is a metal layer containing silver or a silver alloy, it has a high average reflectivity for near infrared ray, and heat rays such as sunlight can be effectively blocked.

Furthermore, in the light transmitting film 1, when the metal layer 6 is a metal layer containing silver or a silver alloy, it has a high average reflectivity for near infrared ray, and heat rays such as sunlight can be effectively blocked.

Furthermore, in the light transmitting film 1, when the ratio of the thickness T2 of the second inorganic oxide layer 7 relative to the thickness T1 of the first inorganic oxide layer 5 (T2/T1) is 0.5 or more and 1.5 or less, deterioration of the metal layer 6 can be suppressed.

Furthermore, in the light transmitting film 1, the first inorganic oxide layer 5 and the second inorganic oxide layer 7 further contains carbon atoms, and when a total of the hydrogen atom content H1 and the carbon atom content C1 of the first inorganic oxide layer 5 (H1 + C1), and a total of the hydrogen atom content H2 and the carbon atom content C2 of the second inorganic oxide layer 7 (H2 + C2) are both 6 × 10¹⁹atoms/cm³ or more and 10,000 × 10¹⁹atoms/cm³ or less, the light transmitting inorganic layer 4 has excellent amorphous characteristics, and etching properties can be kept further reliably.

### 11. Modified example

In the modified example, for the same members and steps of the above-described embodiment, the same reference numerals are given and detailed descriptions are omitted.

In one embodiment, ITO is given as an example of inorganic oxide of the first inorganic oxide layer 5 and the second inorganic oxide layer 7, but for example, one of the first inorganic oxide layer 5 and the second inorganic oxide layer 7 can contain ITO as inorganic oxide and the other of the first inorganic oxide layer 5 and the second inorganic oxide layer 7 can contain inorganic oxide other than ITO (e.g., TiOx, IZO, IGO, IGZO, etc.) as inorganic oxide.

In one embodiment, as shown in FIG. 1, the light transmitting inorganic layer 4 is provided on the transparent substrate 2 but although not shown, the light transmitting inorganic layer 4 can be further provided below the transparent substrate 2. That is, the light transmitting film 1 can include on both above and below the transparent substrate 2, in this order, the protection layer 3 and the light transmitting inorganic layer 4.

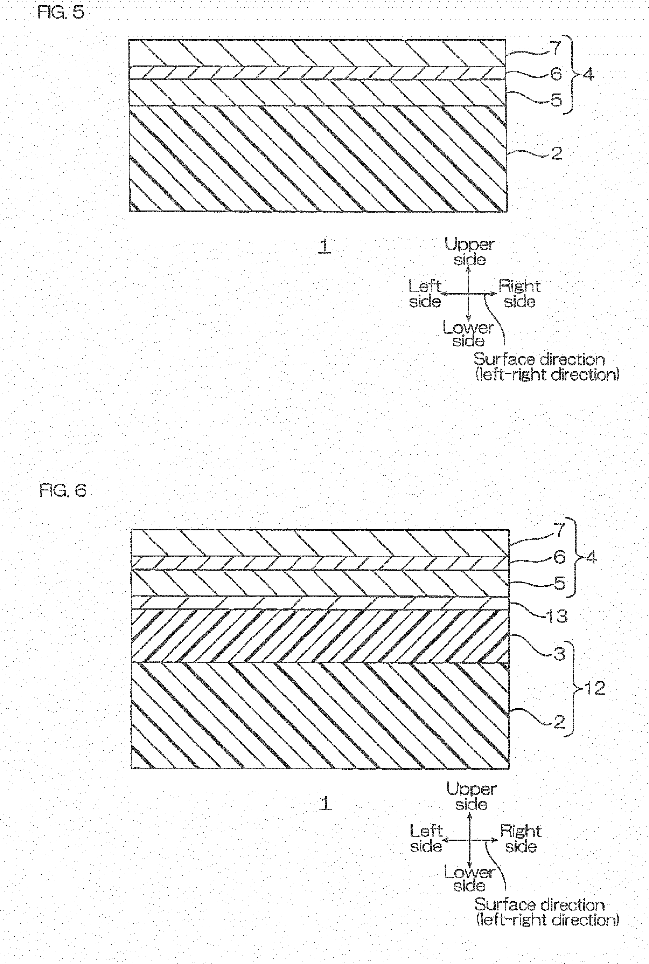

In one embodiment, as shown in FIG. 1, the protection layer 3 is interposed between the transparent substrate 2 and the first inorganic oxide layer 5. However, for example, as shown in FIG. 5, the first inorganic oxide layer 5 can be directly disposed on the top face of the transparent substrate 2. That is, the light transmitting film 1 include, in this order, the transparent substrate 2, the first inorganic oxide layer 5, the metal layer 6, and the second inorganic oxide layer 7. Meanwhile, the light transmitting film 1 does not include the protection layer 3.

In one embodiment, as shown in FIG. 1, the first inorganic oxide layer 5 is directly disposed on the top face of the protection layer 3. However, for example, as shown in FIG. 6, the inorganic substance layer 13 can be interposed between the protection layer 3 and the first inorganic oxide layer 5.

The inorganic substance layer 13 is an optical adjustment layer (second optical adjustment layer), along with the protection layer 3, to adjust optical properties of the light transmitting film 1 so as to suppress visibility of the wiring pattern in the light transmitting inorganic layer 4. The inorganic substance layer 13 has a film form (including sheet form), and is disposed on the entire top face of the protection layer 3 so as to contact the top face of the protection layer 3. The inorganic substance layer 13 has predetermined optical properties, and for example, is prepared from inorganic substance such as oxide, fluoride. The inorganic substance layer 13 has a thickness of 1 nm or more, preferably 5 nm or more, more preferably 10 nm or more, and for example, 80 nm or less, preferably 40 nm or less, more preferably 25 nm or less.

### [Examples]

The present invention will be described hereinafter in further detail with reference to Examples and Comparative Examples. However, the present invention is not limited to these Examples and Comparative Examples. The specific numeral values such as the mixing ratio (content), physical property values, and parameters used in the description below can be replaced with the upper limit value (numeral values defined with "or less", "less than") or the lower limit value (numeral values defined with "or more", "more than") of the corresponding mixing ratio (content), physical property values, and parameters in the above-described "DESCRIPTION OF EMBODIMENTS".

### Example 1

### (Preparation of film substrate and formation of protection layer)

First, a transparent substrate composed of an elongated polyethylene terephthalate (PET) film and having a thickness of 50 µm was prepared. The prepared transparent substrate has a moisture content of 19 µg/cm², and the water content of the transparent substrate was 0.27 mass%.

Then, an ultraviolet ray curable resin composed of acrylic resin was applied on the top face of the transparent substrate, and cured by ultraviolet ray application, thereby forming a protection layer composed of a curable resin layer and having a thickness of 2 µm. The protection layer-provided transparent substrate roll including the transparent substrate and the protection layer was produced in this manner.

### (Formation of first inorganic oxide layer)

Then, the protection layer-provided transparent substrate roll was placed statically in a vacuum sputtering device, and evacuation was conducted until the atmospheric pressure at the time of non-transportation was 4 × 10⁻³Pa (degassing). At that time, a portion of the protection layer-provided transparent substrate was transported while not introducing sputtering gas (Ar and O₂), and it was confirmed that the atmospheric pressure increased till 2 × 10⁻²Pa. In this manner, it was confirmed that sufficient amount of gas was remained in the protection layer-provided transparent substrate roll.

Then, while sending out the protection layer-provided transparent substrate roll, a first inorganic oxide layer composed of an indium tin oxide layer and having a thickness of 42 nm was formed on the top face of the curable resin layer by sputtering.

To be specific, a target composed of sintered body of 10 mass% tin oxide and 90 mass% indium oxide was sputtered under vacuum atmosphere with an atmospheric pressure of 0.3Pa (flow rate ratio Ar: O₂ = 100: 1.4) to which Ar and O₂ were introduced using a direct current (DC) power source.

When forming the first inorganic oxide layer by sputtering, the lower face (to be specific, lower face of the transparent substrate) of the protection layer-provided transparent substrate roll is allowed to contact a chill roll of -5°C, thereby cooling the protection layer-provided transparent substrate roll.

### (Formation of metal layer)

A metal layer composed of an Ag-Pd alloy and having a thickness of 8 nm was formed on the top face of the first inorganic oxide layer by sputtering.

To be specific, an Ag-Pd target (Pd content: 0.5 mass%) was sputtered under a vacuum atmosphere with an atmospheric pressure of 0.3Pa to which Ar was introduced using a direct current (DC) power source as a power source.

### (Formation of second inorganic oxide layer)

A second inorganic oxide layer composed of ITO and having a thickness of 40 nm was formed on the top face of the metal layer by sputtering.

To be specific, a target composed of a sintered body of 10 mass% tin oxide and 90 mass% indium oxide was sputtered under a vacuum atmosphere with an atmospheric pressure of 0.4Pa to which Ar and O₂ was introduced (flow rate ratio Ar: O₂ = 100: 1.5) using a direct current (DC) power source.

The time required for the start of the formation of the first inorganic oxide layer and the end of the formation of the second inorganic oxide layer was, that is, the time required for formation of the light transmitting inorganic layer was 3.5 minutes.

In this manner, a light transmitting film in which a protection layer, a first inorganic oxide layer, a metal layer, and a second inorganic oxide layer were formed in this order was formed on the transparent substrate.

### Example 2

A light transmitting film was produced in the same manner as in Example 1, except that the atmospheric pressure after the protection layer-provided transparent substrate roll was set in a vacuum sputtering device at the time of non-transportation was changed to 4 × 10⁻⁴Pa, a first inorganic oxide layer and a second inorganic oxide layer were formed using a target composed of sintered body of 12 mass% tin oxide and 88 mass% indium oxide, and the time required for forming the light transmitting inorganic layer was changed from 3.5 minutes to 0.7 minutes.

### Example 3

A light transmitting film was produced in the same manner as in Example 2, except that the discharge output at the time of sputtering the Ag-Pd target was decreased by 25%, and the thickness of the metal layer was changed to 6 nm.

### Example 4

A light transmitting film was produced in the same manner as in Example 2, except that the discharge output at the time of sputtering Ag-Pd the target was increased by 25%, and the thickness of the metal layer was changed to 10 nm.

### Comparative Example 1

A light transmitting film was produced in the same manner as in Example 1, except that the atmospheric pressure after the protection layer-provided transparent substrate roll was set in a vacuum sputtering device and at the time of non-transportation was changed from 4 × 10⁻³Pa to 9 × 10⁻⁵Pa, and the time required for forming the light transmitting inorganic layer was changed from 3.5 minutes to 180 minutes.

### (Measurement)

### (1) Thickness

The thickness of the protection layer, the first metal oxide layer, the metal layer, and the second metal oxide was measured by cross sectional observation using a transmission electron microscope (manufactured by Hitachi, Ltd., H-7650).

The thickness of the substrate was measured using a thickness gauge (manufactured by OZAKI MFG.CO.,LTD., digital dial gauge DG-205).

### (2) Hydrogen atom content and carbon atom content

The hydrogen atom content and the carbon atom content (H1, C1) of the first inorganic oxide layer were measured using a Secondary Ion Mass Spectrometer (device name "PHI ADEPT-1010", manufactured by ULVAC-PHI, INCORPORATED.) by Secondary Ion Mass Spectrometry. To be specific, the hydrogen atom content (H1) and the carbon atom content (C1) of the first inorganic oxide layer at a center portion in the thickness direction were measured by Secondary Ion Mass Spectrometry.

The hydrogen atom content (H2) and the carbon atom content (C2) of the second inorganic oxide layer were measured in the same manner as in the measurement of the first inorganic oxide layer.

### (3) Specific resistance of light transmitting inorganic layer

The specific resistance of the light transmitting inorganic layer was calculated based on the product of the surface resistance value of the light transmitting inorganic layer measured in conformity with a four-point probe array of JIS K7194 (1994), and the thickness of the light transmitting inorganic layer obtained in (1) measurement of thickness. The results are shown in Table 1.

### (4) Etching properties

The photosensitive film (DFR, trade name "RY 33 10", manufactured by Hitachi Chemical Co., Ltd.) was disposed on the entire top face of the light transmitting inorganic layer 4, and then, as shown in FIG. 2, a photo mask having a pattern of the non-pattern portion and formation of the pattern portion is exposed to light, and thereafter, the photosensitive film corresponding to the non-pattern portion is removed by developing. In this manner, an etching resist 13 having the same pattern as that of the pattern portion was formed on the top face of the light transmitting inorganic layer 4 that is going to be a pattern portion. Thereafter, the light transmitting inorganic layer 4 exposed from the etching resist 13 was immersed in an etching solution (manufactured by ADEKA Corporation, CHELUMICA SET-500) heated to 40°C for 30 seconds to perform etching.

In this manner, as shown in FIG. 2, the light transmitting inorganic layer 4 was formed into a wiring pattern having a striped pattern portion. The pattern portion had a width L of 100 µm, and the non-pattern portion had a width S (that is, space S of adjacent pattern portions) of 100 µm.

Thereafter, in a resist-provided light transmitting inorganic layer pattern, TEM observation of the first inorganic oxide layer and the second inorganic oxide layer for presence or absence of over etched portions was conducted, and etching properties were evaluated based on the following criteria. No over etched portion was observed for the second inorganic oxide layer.

The "length in the width direction of over etched portion" below is distance D from the end edge of the second inorganic oxide layer to, in the first inorganic oxide layer, the innermost portion (deepest portion) of the portion eroded inward.

### Criteria

Good: The length D in the width direction of over etched portion of first inorganic oxide layer is less than 10 µm.

Average: The length D in the width direction of over etched portion of first inorganic oxide layer is 10 µm or more and less than 15 µm.

Bad: The length D in the width direction of over etched portion of first inorganic oxide layer is 15 µm or more.

### (5) Optical characteristics

The total luminous transmittance was measured using a haze meter (manufactured by Suga Test Instruments Co.,Ltd., device name "HGM-2DP), and the result is regarded as visible light transmission.

A black plate with an adhesive was bonded to the light transmitting film of Examples and Comparative Examples so as to avoid entrance of bubbles to the side opposite of the light transmitting inorganic layer. Then, using a spectrophotometer (manufactured by Hitachi High-Technologies Corporation "U-4100"), a reflectance for near infrared ray region (850 to 2500 nm) was measured with 5 nm pitch, thereby calculating an average value of the reflectance of the light transmitting inorganic layer (average reflectivity).

The results are shown in Table 1.

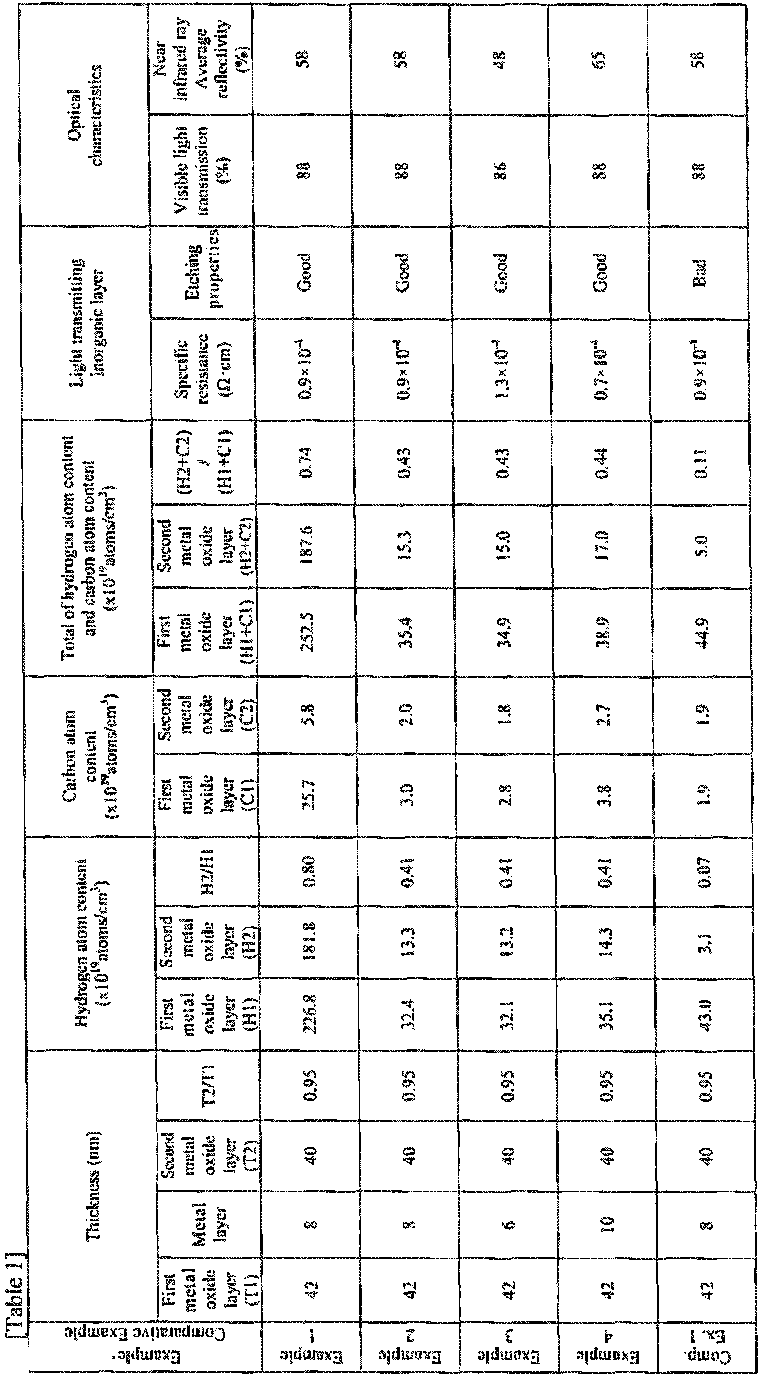

While the illustrative embodiments of the present invention are provided in the above description, such is for illustrative purpose only and it is not to be construed as limiting in any manner. Modification and variation of the present invention which will be obvious to those skilled in the art are to be covered in the following claims.

### Industrial Applicability

The light transmitting film is used, for example, for optical devices.

### [Description of reference numeral]

- 1: Light transmitting film
- 2: Transparent substrate
- 4: Light transmitting inorganic layer
- 5: First inorganic oxide layer
- 6: Metal layer
- 7: Second inorganic oxide layer

## Claims

1. A light transmitting film comprising a transparent substrate and a light transmitting inorganic layer in this order,
wherein the transparent substrate is composed of a polymer film,
the light transmitting inorganic layer comprises, in this order, a first inorganic oxide layer, a metal layer, and a second inorganic oxide layer, so that the second inorganic oxide layer is the uppermost layer of the light transmitting inorganic layer,
the light transmitting inorganic layer has conductivity,
the first inorganic oxide layer and the second inorganic oxide layer contain hydrogen atoms,
the ratio of the hydrogen atom content H2 of the second inorganic oxide layer relative to the hydrogen atom content H1 of the first inorganic oxide layer (H2/H1) is 0.10 or more and 10.00 or less, and
the first inorganic oxide layer contains, as a main component, inorganic oxide, wherein the inorganic oxide includes metal oxide formed from at least one metal selected from the group consisting of In, Sn, Zn, Ga, Sb, Ti, Si, Zr, Mg, Al, Au, Ag, Cu, Pd, and W, and the second inorganic oxide layer includes metal oxide formed from at least one metal selected from the group consisting of In, Sn, Zn, Ga, Sb, Ti, Si, Zr, Mg, Al, Au, Ag, Cu, Pd and W;
wherein the first inorganic oxide layer and the second inorganic oxide layer further contain carbon atoms, and
a total content of the hydrogen atom content H1 and the carbon atom content C1 of the first inorganic oxide layer (H1 + C1), and a total content of the hydrogen atom content H2 and the carbon atom content C2 of the second inorganic oxide layer (H2 + C2) are both 6 × 10¹⁹atoms/cm³ or more and 10,000 × 10¹⁹atoms/cm³ or less, and wherein the hydrogen atom content and the carbon atom content (H1, H2, C1, and C2) are measured using Secondary Mass Spectrometry according to the description.

2. The light transmitting film according to Claim 1, wherein the hydrogen atom content H1 of the first inorganic oxide layer and the hydrogen atom content H2 of the second inorganic oxide layer are both 5 × 10¹⁹atoms/cm³ or more and 8,000 × 10¹⁹atoms/cm³ or less.

3. The light transmitting film according to Claim 1, wherein at least one of the first inorganic oxide layer and the second inorganic oxide layer contains indium oxide.

4. The light transmitting film according to Claim 1, wherein both of the first inorganic oxide layer and the second inorganic oxide layer are amorphous.

5. The light transmitting film according to Claim 1, wherein the ratio of the thickness T2 of the second inorganic oxide layer relative to the thickness T1 of the first inorganic oxide layer (T2/T1) is 0.5 or more and 1.5 or less.

## Patentansprüche

1. Lichtdurchlässiger Film, umfassend ein transparentes Substrat und eine lichtdurchlässige anorganische Schicht in dieser Reihenfolge,
wobei das transparente Substrat aus einem Polymerfilm zusammengesetzt ist,
wobei die lichtdurchlässige anorganische Schicht, in dieser Reihenfolge, eine erste anorganische Oxidschicht, eine Metallschicht und eine zweite anorganische Oxidschicht umfasst, so dass die zweite anorganische Oxidschicht die oberste Schicht der lichtdurchlässigen anorganischen Schicht ist,
wobei die lichtdurchlässige anorganische Schicht eine Leitfähigkeit besitzt,
wobei die erste anorganische Oxidschicht und die zweite anorganische Oxidschicht Wasserstoffatome enthalten,
wobei das Verhältnis des Wasserstoffatomgehalts H2 der zweiten anorganischen Oxidschicht zum Wasserstoffatomgehalt H1 der ersten anorganischen Oxidschicht (H2/H1) 0,10 oder mehr und 10,00 oder weniger ist, und
die erste anorganische Oxidschicht, als Hauptkomponente, ein anorganisches Oxid enthält, wobei das anorganische Oxid Metalloxid beinhaltet, das aus mindestens einem Metall gebildet ist, das aus der Gruppe ausgewählt ist, die aus In, Sn, Zn, Ga, Sb, Ti, Si, Zr, Mg, Al, Au, Ag, Cu, Pd und W besteht, und die zweite anorganische Oxidschicht Metalloxid beinhaltet, das aus mindestens einem Metall gebildet ist, das aus der Gruppe ausgewählt ist, die aus In, Sn, Zn, Ga, Sb, Ti, Si, Zr, Mg, Al, Au, Ag, Cu, Pd und W besteht;
wobei die erste anorganische Oxidschicht und die zweite anorganische Oxidschicht weiter Kohlenstoffatome enthalten, und
ein Gesamtgehalt des Wasserstoffatomgehalts H1 und des Kohlenstoffatomgehalts C1 der ersten anorganischen Oxidschicht (H1 + C1), und ein Gesamtgehalt des Wasserstoffatomgehalts H2 und des Kohlenstoffatomgehalts C2 der zweiten anorganischen Oxidschicht (H2 + C2) beide 6 × 10¹⁹ Atome/cm³ oder mehr und 10,000 × 10¹⁹ Atome/cm³ oder weniger sind, und wobei der Wasserstoffatomgehalt und der Kohlenstoffatomgehalt (H1, H2, C1 und C2) unter Verwenden von Sekundärmassenspektrometrie gemäß der Beschreibung gemessen werden.

2. Der lichtdurchlässige Film nach Anspruch 1, wobei der Wasserstoffatomgehalt H1 der ersten anorganischen Oxidschicht und der Wasserstoffatomgehalt H2 der zweiten anorganischen Oxidschicht beide 5 × 10¹⁹ Atome/cm³ oder mehr und 8,000 × 10¹⁹ Atome/cm³ oder weniger sind.

3. Der lichtdurchlässige Film nach Anspruch 1, wobei mindestens eine der ersten anorganischen Oxidschicht und der zweiten anorganischen Oxidschicht Indiumoxid enthält.

4. Der lichtdurchlässige Film nach Anspruch 1, wobei die erste anorganische Oxidschicht und die zweite anorganische Oxidschicht beide amorph sind.

5. Der lichtdurchlässige Film nach Anspruch 1, wobei das Verhältnis der Dicke T2 der zweiten anorganischen Oxidschicht zur Dicke T1 der ersten anorganischen Oxidschicht (T2/T1) 0,5 oder mehr und 1,5 oder weniger ist.

## Revendications

1. Film de transmission de lumière comprenant, dans cet ordre, un substrat transparent et une couche inorganique de transmission de lumière, dans lequel
le substrat transparent est composé d'un film polymère,
la couche inorganique de transmission de lumière comprend, dans cet ordre, une première couche d'oxyde inorganique, une couche métallique, et une deuxième couche d'oxyde inorganique, de telle sorte que la deuxième couche d'oxyde inorganique est la couche la plus élevée de la couche inorganique de transmission de lumière,
la couche inorganique de transmission de lumière présente une conductivité,
la première couche d'oxyde inorganique et la deuxième couche d'oxyde inorganique contiennent des atomes d'hydrogène,
le ratio de la teneur en atomes d'hydrogène H2 de la deuxième couche d'oxyde inorganique par la teneur en atomes d'hydrogène H1 de la première couche d'oxyde inorganique (H2/H1) est supérieur ou égal à 0,10 et inférieur ou égal à 10,00, et
la première couche d'oxyde inorganique contient, comme composant principal, un oxyde inorganique, dans lequel l'oxyde inorganique comprend un oxyde métallique constitué d'au moins un métal sélectionné dans le groupe constitué par In, Sn, Zn, Ga, Sb, Ti, Si, Zr, Mg, Al, Au, Ag, Cu, Pd et W, et la deuxième couche d'oxyde inorganique comprend un oxyde métallique constitué d'au moins un métal sélectionné dans le groupe constitué par In, Sn, Zn, Ga, Sb, Ti, Si, Zr, Mg, Al, Au, Ag, Cu, Pd et W ;
dans lequel la première couche d'oxyde inorganique et la deuxième couche d'oxyde inorganique contiennent en outre des atomes de carbone, et
la teneur totale en atomes d'hydrogène H1 et en atomes de carbone C1 de la première couche d'oxyde inorganique (H1 + C1) et la teneur totale en atomes d'hydrogène H2 et en atomes de carbone C2 de la deuxième couche d'oxyde inorganique (H2 + C2) sont toutes deux supérieures ou égales à 6 × 10¹⁹ atomes/cm³ et inférieures ou égales à 10 000 × 10¹⁹ atomes/cm³, et dans lequel la teneur en atomes d'hydrogène et la teneur en atomes de carbone (H1, H2, C1 et C2) sont mesurées par spectrométrie de masse secondaire conformément à la description.

2. Film de transmission de lumière selon la revendication 1, dans lequel la teneur en atomes d'hydrogène H1 de la première couche d'oxyde inorganique et la teneur en atomes d'hydrogène H2 de la deuxième couche d'oxyde inorganique sont toutes deux supérieures ou égales à 5 × 10¹⁹ atomes/cm³ et inférieures ou égales à 8 000 × 10¹⁹ atomes/cm³.

3. Film de transmission de lumière selon la revendication 1, dans lequel au moins une couche parmi la première couche d'oxyde inorganique et la deuxième couche d'oxyde inorganique contient de l'oxyde d'indium.

4. Film de transmission de lumière selon la revendication 1, dans lequel la première couche d'oxyde inorganique et la deuxième couche d'oxyde inorganique sont toutes deux amorphes.

5. Film de transmission de lumière selon la revendication 1, dans lequel le ratio de l'épaisseur T2 de la deuxième couche d'oxyde inorganique par l'épaisseur T1 de la première couche d'oxyde inorganique (T2/T1) est supérieur ou égal à 0,5 et inférieur ou égal à 1,5.
